# EUROPÄISCHE PATENTSCHRIFT

(11) **EP 2 326 457 B1**
(45) Veröffentlichungstag und Bekanntmachung des Hinweises auf die Patenterteilung: **03.08.2016**
(21) Anmeldenummer: 09782959.2
(22) Anmeldetag: 14.09.2009
(51) Int. Cl.: B23K 35/26, B23K 35/34, B23K 1/00, H05K 3/34, H01L 21/60, B23K 101/40, B23K 35/14

(54) **LOTMATERIAL MIT EINEM REAKTIVEN ZUSATZWERKSTOFF, TRÄGERBAUTEIL ODER BAUELEMENT MIT EINEM SOLCHEN LOTMATERIAL SOWIE VERWENDUNG EINES FLUSSMITTELS**
SOLDER MATERIAL COMPRISING A REACTIVE FILLER MATERIAL, CARRIER ELEMENT OR COMPONENT COMPRISING SAID TYPE OF SOLDER MATERIAL AND USE OF A FLUXING AGENT
PRODUIT DE BRASAGE CONTENANT UN ADDITIF RÉACTIF, ÉLÉMENT DE SUPPORT OU DE CONSTRUCTION CONTENANT UN TEL PRODUIT DE BRASAGE, ET UTILISATION D UN FONDANT

(30) Priorität: 15.09.2008 DE 102008047666; 19.03.2009 DE 102009013919
(43) Veröffentlichungstag der Anmeldung: 01.06.2011
(73) Patentinhaber: Siemens Aktiengesellschaft, 80333 München (DE); Ludeck, Wolfgang, 12623 Berlin (DE)
(72) Erfinder: LUDECK, Wolfgang, 12623 Berlin (DE); MÜLLER, Bernd, 16259 Falkenberg (DE); WITTREICH, Ulrich, 16727 Velten (DE); MEIER, Hartmut, 16321 Bernau (DE); WORMUTH, Dirk, 12203 Berlin (DE); BABATZ, Janet, 16540 Hohen Neuendorf (DE)
(74) Vertreter: Maier, Daniel Oliver
(86) Internationale Anmeldenummer: PCT/EP2009/061857
(87) Internationale Veröffentlichungsnummer: WO 2010/029169

(56) Entgegenhaltungen:
- DE-A1- 19 728 014
- JP-A- 7 136 795
- JP-A- 61 111 765
- US-A- 5 902 498
- DATABASE WPI Week 199234 Thomson Scientific, London, GB; AN 1992-280252 XP002563069 -& JP 04 190995 A (HITACHI LTD) 9. Juli 1992 (1992-07-09)

## Beschreibung

Die Erfindung betrifft ein Lotmaterial, d. h. ein Pulver oder eine Paste, enthaltend Partikel einer Weichlötlegierung mit einem Schmelzpunkt T_{S} oder einer unteren Grenze des Schmelzbereiches T_{S} und einem Zusatzwerkstoff, der in Form einer Paste, eines zugemischten Hartstoffes oder einer Beschichtung der Partikel des Lotmaterials bestehen kann. Wichtig ist, dass die Partikel von dem Zusatzwerkstoff umgeben sind. Dieses Umgebensein kann im Sinne einer Beschichtung oder eines einfachen Angrenzens des Zusatzstoffes an die Partikel derart, dass eine Wärmeübertragung stattfinden kann, verstanden werden.

Weiterhin betrifft die Erfindung auch ein Trägerbauteil mit Kontaktflächen für elektrische Bauelemente oder elektrische Bauelemente oder ein elektrisches Bauelement mit solchen Kontaktflächen, wobei auf den Kontaktflächen Lotdepots mit einem Schmelzpunkt T_{S} oder einer unteren Grenze des Schmelzpunktes T_{S} vorgesehen sind.

Zuletzt betrifft die Erfindung die Verwendung eines Flussmittels für ein Lotmaterial, d. h. ein Pulver, eine Paste oder ein Lothalbzeug, welches aus einer Weichlötlegierung besteht, die einen Schmelzpunkt T_{S} oder eine untere Grenze des Schmelzbereiches T_{S} aufweist.

Allgemein ist es wünschenswert, wenn Lotlegierungen für die Elektronikmontage einen möglichst niedrigen Schmelzpunkt aufweisen. Dies ist mit der Zielstellung verbunden, dass das Löten der elektrischen Kontaktstellen mit einer möglichst qeringen Erwärmung der elektronischen Bauteile einhergehen soll, damit diese nicht beschädigt werden.

Durch Festlegungen beispielsweise in der EU, künftig keine bleihaltigen Legierungen mehr für Lötprozesse zu verwenden, wird eine Verwendung von Lotlegierungen notwendig, die wegen des Wegfalls von Blei höhere Schmelzpunkte aufweisen. Dadurch werden aber auch die zu lötenden Bauelemente stärker thermisch beansprucht. In der Folge führt die Verwendung geeigneter Bauelemente sowie die höheren, notwendigen Prozesstemperaturen zu einer Kostenerhöhung in der Elektronikmontage.

Es wurden in der Vergangenheit daher Ansätze verfolgt, die notwendige Energiemenge zum Aufschmelzen des Lotmaterials zu verringern. Dies kann beispielsweise durch die Zusammensetzung des Lotwerkstoffes erreicht werden, indem Anteile einer niedriger schmelzenden Legierung in dem Lotwerkstoff vorgesehen werden. Diese sogenannten Reaktionslote weisen einen Schmelztemperaturbereich auf, wobei bereits bei Erreichen der unteren Grenze ein Anschmelzen des Lotmaterials und vor dem Erreichen der oberen Grenze ein vollkommenes Aufschmelzen des Lotmaterials erreicht werden kann. Allerdings ist diese Maßnahme durch die Anforderungen an die Legierungsbestandteile im Lotmaterial begrenzt. In der DE 197 28 014 A1 ist angegeben, dass an der Lötstelle auch eine Reaktionskomponente zur Verfügung gestellt werden kann, die bei Erhitzung mit einer weiteren Komponente exotherm reagiert. Die US 5,902,498, JP 07-136795A, JP 04-190995A und JP 61-111765A betreffen weitere Reaktionslote.

Die Aufgabe der Erfindung liegt daher darin, Möglichkeiten für eine Verringerung der notwendigen Löttemperaturen, insbesondere bleifreier Lotlegierungen, aufzuzeigen und diese Möglichkeiten nutzende Lotmaterialien, Trägerbauteile mit Lotkontakten, Bauelemente mit Lotkontakten oder Flussmittel zur Verfügung zu stellen.

Diese Aufgabe wird zunächst durch das eingangs genannte Lotmaterial erfindungsgemäß dadurch gelöst, dass der Zusatzwerkstoff eine reaktive Komponente enthält, die bei einer Temperatur T_{R} exotherm reagiert, wobei die Temperatur T_{R} < T_{S} ist. Die reaktive Komponente kann auch aus mehreren Bestandteilen bestehen, wobei deren Reaktivität durch eine grundsätzliche Fähigkeit gegeben ist, exotherm reagieren zu können. Diese exotherme Reaktion ist insbesondere durch Reaktion mit Sauerstoff, z. B. dem Luftsauerstoff erreichbar. Selbstverständlich kann die exotherme Reaktion auch zwischen verschiedenen Bestandteilen der reaktiven Komponente erfolgen.

Erfindungsgemäß ist vorgesehen, dass die reaktive Komponente, die mit Sauerstoff exotherm reagieren kann, eine Metall-Carbonyl-Verbindung ist. Diese Stoffgruppe hat den Vorteil, dass deren Schmelzpunkt durch eine geeignete Modifikation der chemischen Struktur eingestellt werden kann (hierzu im Folgenden mehr). Auf diese Weise lässt sich die reaktive Komponente vorteilhaft auf den Lotwerkstoff maßschneidern, mit dem sie zur Verwendung kommen soll. Die Reaktion mit Sauerstoff hat weiterhin den Vorteil, dass hierzu der Luftsauerstoff zur Verfügung gestellt werden kann. Dadurch, dass dieser Luftsauerstoff durch die Metall-Carbonyl-Verbindung verbraucht wird, stellt ein solcher Zusatzwerkstoff gleichzeitig einen Oxidationsschutz für andere Komponenten des Lotwerkstoffes dar. Dies macht die Notwendigkeit entbehrlich, den Lötprozess in einem Schutzgas, wie z. B. Stickstoff, durchzuführen. Hierdurch lässt sich vorteilhaft ein weiterer Gewinn an Wirtschaftlichkeit bei Verwendung des erfindungsgemäßen Zusatzwerkstoffes erzielen.

Weiterhin wird die Aufgabe erfindungsgemäß auch durch das eingangs genannte Trägerbauteil mit Kontaktflächen bzw. elektrische Bauelement mit Kontaktflächen gelöst, wobei die auf diesen Kontaktflächen vorgesehenen Lotdepots aus einem Lotmaterial ausgebildet sind, das die vorstehend angegebenen Eigenschaften aufweist, d. h. eine reaktive Komponente enthält.

Weiterhin wird die Aufgabe durch eine erfindungsgemäße Verwendung eines Flussmittels mit einer reaktiven Komponente der vorstehend angegebenen Art gelöst, die bei einer Temperatur T_{R} exotherm reagiert. Die Verwendung soll erfindungsgemäß für ein Lotmaterial, also ein Pulver, eine Paste oder ein Lothalbzeug erfolgen, welches aus einer Weichlotlegierung mit einem Schmelzpunkt T_{S} besteht.

Mit anderen Worten wird durch die Verwendung definiert instabiler, chemischer Verbindungen (nämlich der reaktiven Komponente) beim Lötprozess Energie dadurch frei, dass eine exotherme Reaktion abläuft. Auf diese Weise tritt während der chemischen Umsetzung in der Lötverbindung eine Temperaturerhöhung auf. Durch diese Form der Energiefreisetzung wird zwangsläufig die benötigte, von außen zugeführte Wärmemenge bis zum Schmelzen des Lotes reduziert. Die Reaktion und die damit erreichte zusätzliche Energie bleibt also lokal auf die Lötstelle begrenzt und hat daher kaum Auswirkungen auf die Zuverlässigkeit der umgebenden Materialien (Leiterplatte, Bauelemente). Damit ist eine geringere thermische Belastung der Bauelemente möglich, wodurch vorteilhaft die Auswahl an Bauelementen steigt. Außerdem ist eine geringere Wärmezufuhr durch den Lötofen notwendig, wodurch vorteilhaft Energie gespart wird. Insbesondere können dadurch bleifreie Lötlegierungen, wie z. B. Lotlegierungen auf SnAgCu-Basis unter Bedingungen verarbeitet werden, wie diese bei den bisher üblichen SnPb-Verbindungen üblich waren. Dabei können die gebräuchlichen Lötanlagen, Basismaterialien, Bauelemente und auch Reparatursysteme verwendet werden. Außerdem wird durch Verringerung der Temperaturbelastung beim Löten die Baugruppenzuverlässigkeit und somit die Lebensdauer der gefertigten Baugruppen erhöht, wodurch Qualitätsprobleme vermieden werden können. Auch die Qualität der ausgebildeten Lötverbindungen kann vorteilhaft verbessert werden, da durch die geringere Temperaturbelastung während des Lötens auch die Oxidation der Lötstellen verringert wird. Deswegen kann auch der Einsatz von Stickstoff beim Löten entfallen, was zu weiteren Kostensenkungen führt.

Durch die geringere, notwendige Energiemenge, die der zu lötenden Baugruppe zugeführt werden muss, verkürzen sich weiterhin die Lötzeiten, weswegen vorteilhaft die Durchlaufgeschwindigkeiten innerhalb einer bestehenden Fertigungslinie erhöht werden können. Hierdurch lässt sich ein weiterer Wirtschaftlichkeitsgewinn erreichen. Auch Reparaturprozesse können weitgehend vereinfacht und verkürzt werden. Durch die Herabsetzung des Schmelzpunktes des Lotwerkstoffes ist außerdem der Einsatz bei doppelseitig bestückten Leiterplatten besonders vorteilhaft. Da der Schmelzpunkt der ausgebildeten Lötverbindungen wesentlich höher als die Prozesstemperatur liegt, kann ein Erweichen der Lötverbindungen auf der Vorderseite der Leiterplatte ausgeschlossen werden, wenn in einem zweiten Durchgang die Lötverbindungen auf der Rückseite hergestellt werden.

Gemäß einer Alternative der Erfindung kann das Lotmaterial auch in Form eines Lothalbzeugs vorliegen. Dieses besteht aus einer Weichlotlegierung mit einem Schmelzpunkt T_{S} oder einer unteren Grenze des Schmelzbereiches T_{S} und ist von dem Zusatzwerkstoff umgeben oder der Zusatzwerkstoff ist in dem Lothalbzeug enthalten. Wie schon erläutert, enthält der Zusatzwerkstoff erfindungsgemäß eine reaktive Komponente, die bei einer Temperatur T_{R} exotherm reagiert, wobei T_{R} < T_{S} ist. Die mit diesem Lotmaterial erzielbaren Vorteile sind bereits vorstehend ausführlich erläutert worden. Gemäß einer weiteren Ausgestaltung der Erfindung ist das Lothalbzeug ein Lötdraht, der vorzugsweise hohl ausgeführt ist, so dass der Zusatzwerkstoff in dessen Inneren untergebracht werden kann. Gemäß einer anderen Ausgestaltung ist das Lothalbzeug ein Lotformteil, welches auch als Preform bezeichnet wird und die Gestalt bestimmter Lotdepots, wie beispielsweise Lotkugeln, aufweisen kann. Diese können dann auf die geeignet vorbereiteten Kontaktstellen von Bauelementen oder Trägerbauteilen wie Leiterplatten aufgebracht werden. Vorzugsweise ist das Lotformteil mit dem Zusatzwerkstoff beschichtet.

Weiterhin ist es vorteilhaft, wenn die reaktive Komponente aus einem einen ersten Stoff und einen zweiten Stoff enthaltenden Gemisch besteht, wobei beide Stoffe unabhängig voneinander mit Sauerstoff exotherm reagieren können. Hierdurch ist vorteilhaft eine genauere Einstellung der während des Lötprozesses ablaufenden Reaktionen möglich. Besonders vorteilhaft ist es, wenn der erste Stoff eine Initiatorverbindung, insbesondere eine Metall-Carbonyl-Verbindung ist, die eine geringere Temperatur T_{R1} zur Zersetzung der Initiatorverbindung aufweist als der zweite Stoff, mit einer diesbezüglichen Temperatur T_{R2}. Damit der erste Stoff als Initiatorverbindung wirken kann, muss die Zersetzung des ersten Stoffes bei der Temperatur T_{R1} ausreichen, um eine exotherme Reaktion des zweiten Stoffes einzuleiten. Weiterhin ist es möglich, dass die Zersetzungsprodukte des ersten Stoffes in einem weiteren Reaktionsschritt exotherm reagieren. Die exotherme Reaktion findet vorzugsweise mit Sauerstoff statt.

Durch die Verwendung einer Initiatorverbindung kann vorteilhaft der notwendige Wärmeeintrag in die Lötverbindung zum Auslösen des Lötprozesses weiterhin verringert werden. Dies bedeutet, dass beispielsweise in einem Reflow-Lötofen die Prozesstemperaturen abgesenkt werden können. Der Wärmeeintrag beim Lötvorgang muss lediglich erreichen, dass die Initiatorverbindung reagiert, wodurch die oben beschriebene Kettenreaktion in Gang gesetzt wird und auf diese Weise zunächst der zweite Stoff exotherm reagiert und hierdurch das Lotmaterial aufgeschmolzen wird.

Besonders vorteilhaft ist es, wenn der zweite Stoff ein Metall oder eine Metalllegierung ist, die leichter als der Lotwerkstoff mit Sauerstoff exotherm reagiert. Dies hat den Vorteil, dass der zweite Stoff an der Legierungsbildung der ausgebildeten Lötverbindung beteiligt werden kann. Es ist beispielsweise möglich, dass der zweite Stoff derart ausgewählt wird, dass dieser ohnehin in der auszubildenden Lotlegierung enthalten sein soll. Vorteilhaft wird bei einer Mehrstofflegierung des Lotwerkstoffes die am leichtesten mit Sauerstoff reagierende Komponente ausgewählt. Selbstverständlich sind auch andere Metalle, die keinen Bestandteil der auszubildenden Lotlegierung bilden, verwendbar. Diese müssen in einem Maß verwendet werden, dass sie die Ausbildung der gewünschten Gefügestruktur der Lötverbindung nicht negativ oder sogar positiv beeinflussen. Die Oxide des zweiten Stoffes können beispielsweise an einer gewünschte Gefügeverfestigung der Lötverbindung teilhaben.

Eine weitere vorteilhafte Ausführungsform der Erfindung erhält man, wenn in dem Zusatzstoff ein Sauerstoffträger, insbesondere ein Peroxid enthalten ist, das bei besagter Temperatur T_{R} (oder je nach Anwendungsfall bei T_{R1} oder T_{R2}) Sauerstoff abgibt. Dies hat den Vorteil, dass der für die exotherme Reaktion notwendige Sauerstoff direkt in dem Lotmaterial zur Verfügung gestellt wird und auf diese Weise notwendige Diffusionsprozesse des Sauerstoffes aus der Atmosphäre in das Innere des Lotmaterials nicht notwendig sind. Außerdem kann, wenn dies aus anderen Gründen notwendig ist, in Schutzatmosphäre unter Sauerstoffabschluss gelötet werden, da der Reaktionspartner für die exotherme Reaktion im Inneren des Lotmaterials zur Verfügung gestellt wird.

Weiterhin wird die Aufgabe auch durch ein Trägerbauteil mit Kontaktflächen für elektrische Bauelemente oder auch durch ein elektrisches Bauelement mit Kontaktflächen, auf denen Lotdepots mit einem Schmelzpunkt T_{S} oder einer unteren Grenze des Schmelzbereiches T_{S} vorgesehen sind, gelöst, indem die Lotdepots aus einem Lotmaterial gemäß den vorher erläuterten Ansprüchen ausgebildet sind. Hierdurch entstehen vorbereitete Bauteile, die gemäß der Erfindung auf einfache Weise und vorteilhaft, insbesondere bei geringeren Löttemperaturen verarbeitet werden können. Die hiermit verbundenen Vorteile sind bereits erläutert worden.

Zuletzt wird die Aufgabe auch durch Verwendung eines Flussmittels mit einer reaktiven Komponente gelöst, die bei einer Temperatur T_{R} exotherm reagiert, wobei ein Lotmaterial aus einer Weichlotlegierung mit einem Schmelzpunkt T_{S} oder einer unteren Grenze des Schmelzbereiches T_{S} zum Einsatz kommt (wobei T_{R} < T_{S} ist). Mit diesem Flussmittel kann also ein Lotmaterial nach dem Stand der Technik im Sinne der Erfindung verbessert werden, so dass ein Löten mit verringerten Temperaturen ermöglicht wird. Dieses führt dann in der bereits beschriebenen Weise zu einem zusätzlichen Wärmeeintrag aus dem Flussmittel in das Lotmaterial, sobald die exotherme Reaktion der reaktiven Komponente in dem Flussmittel ausgelöst wird. Da das Flussmittel in direktem Kontakt mit dem Lotmaterial steht, ist eine schnelle Wärmeübertragung zur Unterstützung des Lötprozesses gewährleistet. Für die besonderen Ausgestaltungen der reaktiven Komponenten im Flussmittel gilt das zu der verwendeten reaktiven Komponente in dem Lotmaterial Beschriebene entsprechend. Dabei kommen Metall-Carbonyl-Verbindungen zum Einsatz. Es kann zusätzlich ein zweiter Stoff als reaktive Komponente zum Einsatz kommen, welcher insbesondere ein Metall oder eine Metalllegierung ist. Es kann ein Zusatzstoff verwendet werden, der Sauerstoff für die exotherme Reaktion zur Verfügung stellt. Der erste Stoff kann als Initiatorverbindung verwendet werden (was insbesondere durch Verwendung einer Metall-Carbonyl-Verbindung als erste Komponente gewährleistet wird). Weitere Einzelheiten der Erfindung sind nachfolgend anhand der Zeichnung beschrieben. Gleiche oder sich entsprechende Zeichnungselemente sind jeweils mit den gleichen Bezugszeichen versehen und werden nur insoweit mehrfach erläutert, wie sich Unterschiede zwischen den einzelnen Figuren ergeben. Es zeigen
Figur 1 bis Figur 3 unterschiedliche Ausführungsbeispiele des Lotmaterials als Paste, Draht oder auf einem Trägerbauteil,
Figur 4 schematisch den Temperaturverlauf bei Verwendung des erfindungsgemäßen Lotmaterials während des Lötens und
Figur 5 bis 6 beispielhaft mögliche Strukturformeln von zur erfindungsgemäßen Verwendung geeigneten Metall-Carbonyl-Verbindungen.

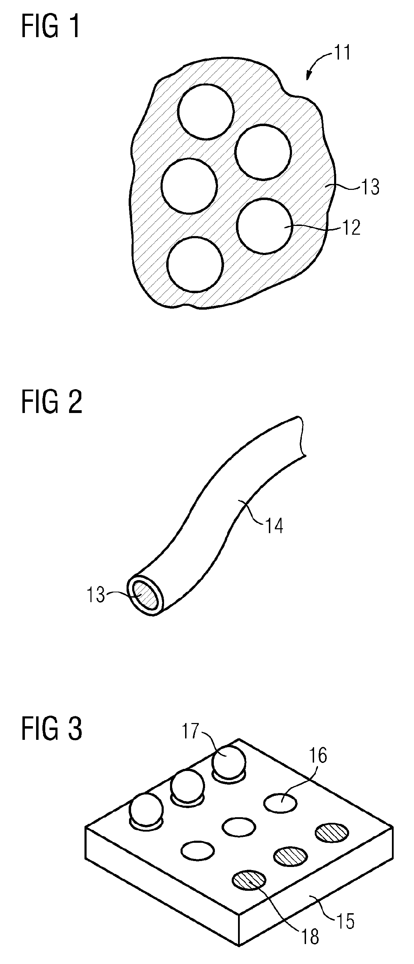

In Figur 1 ist ein Lotmaterial 11 dargestellt, welches Lotpartikel 12 aus einer Lotlegierung aufweist und einen pastenförmigen Zusatzwerkstoff 13, in dem die Lotpartikel 12 eingebracht sind. Der Zusatzwerkstoff ist in nicht näher dargestellter Weise mit der erfindungsgemäßen reaktiven Komponente ausgestattet.

Wie in Figur 2 zu erkennen ist, kann das Lotmaterial auch in Form eines Lothalbzeuges 14 ausgebildet sein. Dieses ist im Ausführungsbeispiel gemäß Figur 2 röhrenförmig, wobei der die reaktive Kommponente enthaltende Zusatzwerkstoff 13 im Inneren der ausgebildeten Röhre vorgesehen ist. Dort unterstützt er den Aufschmelzprozess des Lothalbzeuges beispielsweise beim manuellen Löten.

In Figur 3 ist ein Bauelement 15 vereinfacht dargestellt, welches Kontaktflächen 16 aufweist. Diese können mit Lotformteilen 17 versehen werden (dargestellt sind Lotkugeln), welche beispielsweise mit dem erfindungsgemäßen Zusatzwerkstoff beschichtet sind. Eine andere Möglichkeit ist die Beschichtung der Kontaktflächen 16 mit einem Flussmittel 18, welches die erfindungsgemäße reaktive Komponente enthält.

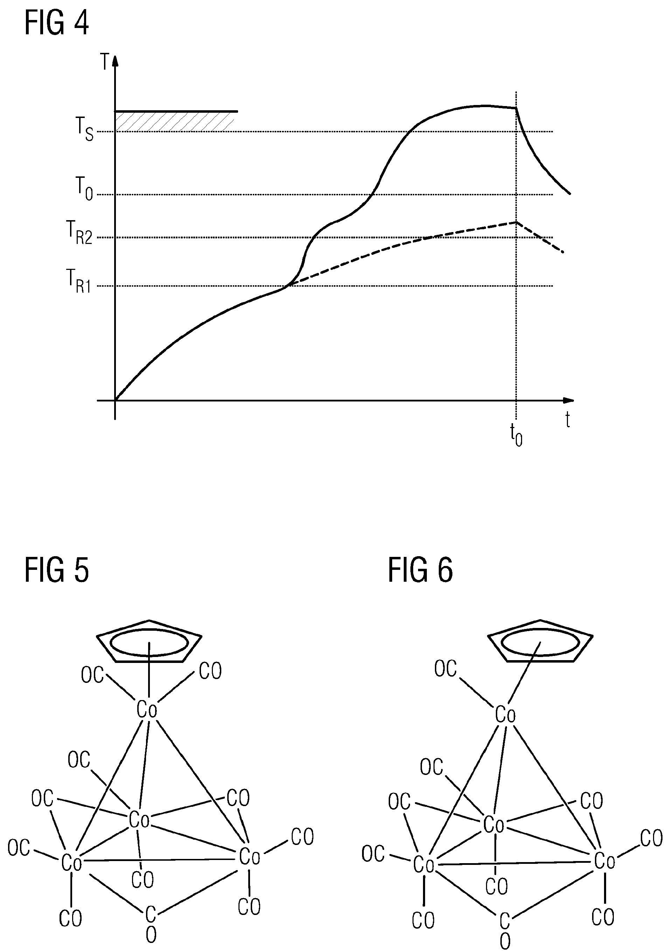

In Figur 4 ist schematisch der Verlauf der Temperatur T in einer auszubildenden Lötverbindung in Abhängigkeit von der Zeit t als durchgezogene Kurve dargestellt. In dem Reflow-Lötofen, in dem die Lötverbindung erzeugt werden soll, herrscht die Temperatur T_{O}. Durch Einbringen einer Baugruppe mit den vorbereiteten Lotdepots steigt die Temperatur zunächst derart an, dass sie sich der Temperatur T_{O} asymptotisch nähert. Bei Erreichen einer Temperatur T_{R1} wird jedoch die Oxidation einer Metall-Carbonyl-Verbindung als Initiatorverbindung in den Lotdepots ausgelöst, was zu einem zusätzlichen Wärmeeintrag führt. Dies ist der Grund, warum ein sprunghafter Temperaturanstieg in den Lotdepots zu verzeichnen ist, während sich die Erwärmung der restlichen elektronischen Baugruppe entsprechend der gestrichelt dargestellten Linie langsamer vollzieht (asymptotische Annäherung an die Ofentemperatur T_{O}). Der Anstieg der Temperatur in den Lotdepots führt jedoch zu einem Überschreiten der Temperatur T_{R2}, bei der eine weitere reaktive Komponente, beispielsweise ein leicht oxidierendes Metall, ebenfalls exotherm mit Luftsauerstoff reagiert. Hierdurch steigt die Temperatur in den Lotdepots schnell weiter, übersteigt auch die Ofentemperatur T_{O} und führt bei Überschreiten der Schmelztemperatur T_{S} zu einem Aufschmelzen der Lötlegierung. Hierbei ist die Schmelzwärme aufzubringen, weswegen der Temperaturanstieg nach Überschreiten von T_{S} gedämpft wird. Bei Erreichen der erforderlichen Lötzeit t_{O} wird der Lötvorgang abgebrochen, wobei die Lötverbindungen erstarren. Diese Zeit t_{O} liegt vorteilhaft unterhalb der normalerweise für die betreffende Lotlegierung erforderlichen Lötzeiten.

T_{S} kennzeichnet die Schmelztemperatur der Lotlegierung oder die untere Grenze eines Schmelzbereiches der Lötlegierung, wobei ein solcher Schmelzbereich in Figur 4 schraffiert angedeutet ist.

Im Folgenden wird die Erzeugung besonderer Ausführungsbeispiele des erfindungsgemäßen Lotmaterials noch näher beschrieben.

Ausgangsmaterial für die Untersuchungen war die Lotpaste F 610 der Firma Heraeus. Der Hauptbestandteil dieser Lotpaste wird durch die Legierung Sn95, 5Ag4CuO, 5 gebildet. Dazu kommen noch Lösungsmittel und Löthilfsstoffe wie z.B. Naturharze. Diese Paste wurde ausgewählt, weil sie im Rahmen anderer Forschungsthemen recht gut untersucht worden ist. Es ist dadurch auch bekannt, dass die Lagerstabilität dieses Produktes nicht sehr hoch ist. Im Gegensatz zu Lotpulvern ist jedoch das Handling mit einer Paste wesentlich einfacher als mit entsprechenden pulvrigen Stoffen, insbesondere dann, wenn die Korngröße im unteren µm-Bereich liegt (etwa 15 µm bis 50 µm) und die Dichte der verwendeten Zusatzstoffe relativ gering ist. Es waren daher keine zusätzlichen apparativen Maßnahmen erforderlich um die Homogenität der Proben zu gewährleisten und Störungen beim Versuchsablauf zu vermeiden. Eine Versuchsablauf ist exemplarisch in Figur 4 dargestellt (Temperaturverlauf T über der Zeit t).

Eine erste Maßnahme bestand darin, dass ein Opfermetall in geringer Menge in die Lotpaste eingearbeitet wird, das eine sehr stärkere Affinität zu Sauerstoff hat als die eigentlichen Lotmetalle, also bereits bei Temperaturen T_{R2}, die im Lötprozess gebräuchlich sind, oxidiert.

Zur besseren Aktivierung dieser Reaktion wurde dem System ein weiterer Stoff zugesetzt, der sich bereits bei niedrigerer Temperatur T_{R1} zersetzt, selbst oxidierbare Bestandteile dabei bildet und in der Gesamtreaktion Energie freisetzt, die damit die Oxidationsreaktion des Opfermetalls unterstützt. Bevorzugt werden dafür Metallcarbonyle verwendet. Diese Metallcarbonyle könnte auch allein den gewünschten thermischen Effekt erzeugen. Aus wirtschaftlichen Erwägungen ist es aber sinnvoll, ein billigeres Opfermetall mit zu verwenden.

Neben den reinen Metallen können dafür auch Metallverbindungen oder -legierungen verwendet werden, sie müssen jedoch so stabil sein, dass ein normales Handling möglich ist. Die zur Anwendung gelangten Metallcarbonyle können einkernig sein oder mehrere gleich- oder verschiedenartige Metallkerne aufweisen.

Bei der Auswahl der Opfermetalle spielen neben der Affinität zum Sauerstoff auch die Mischbarkeit mit der Lotpaste (die Dichte sollte vorteilhaft unter 5 g/cm³ liegen, also im Bereich der Leichtmetalle), die leichte Anfertigung eines feinkörnigen Pulvers, d.h. die einzelnen Körner dürfen nicht zusammenbacken, die Lagerstabilität und das physiologische Verhalten eine Rolle. Darüber hinaus muss die Beschaffbarkeit gesichert und der Preis angemessen sein. Als bevorzugte Metalle sind Magnesium, Aluminium, Zink, Cer, Titan und Nickel zu betrachten. Neben der zu erwartenden Oxidation ist auch eine Reduktion von vorhandenem Zinnoxid auf dem Lotmaterial möglich, was den positiven Effekt dieser Umsetzung noch unterstützt.

Von den vielen instabilen organischen und anorganischen Verbindungen, die sich als Initiator eignen, wurden Metallcarbonyle ausgewählt. Diese Verbindungsklasse zeichnet sich durch die Anwesenheit eines oder mehrerer Metallatome im Mol aus, um die je nach Elektronenkonfiguration CO-Gruppierungen angeordnet sind. Entsprechend den Reaktionsbedingungen und Ausgangsstoffe erhält man sogenannte "homoleptische"(nur eine Ligandenart) oder "heteroleptische" Carbonylverbindungen (unterschiedliche Ligandenarten). Werden unterschiedliche Metalle als Zentralatome verwendet, spricht man von "isoleptischen" Carbonylen bzw. Komplexen. Es können sich dabei einkernige Verbindungen bilden, die unter Energieeinwirkung weiter zu binären Carbonylverbindungen reagieren können. Bei der Herstellung selbst geht man von einem fein verteilten Metall oder Metallgemisch aus, an dem direkt CO unter entsprechenden Bedingungen angelagert wird. Die von der Ausbeute her besonders vorteilhaften Synthesemöglichkeiten über die entsprechenden Halogenverbindungen sind wegen möglicher Verunreinigungen der Endprodukte nicht angewendet worden.

Besonders leicht reagiert Nickel mit CO. Bei 80°C erfolgt die Umsetzung bei Normaldruck mit befriedigender Ausbeute. Vorteilhaft ist dafür ein rotierendes Reaktionsgefäß bei dem die Achse horizontal angeordnet ist.

Nachfolgend soll auch der Reaktionsablauf am Beispiel einer Cobaltverbindung dargestellt werden:

Co + 4 CO → Co(CO)₄

Da die gebildete einkernige Verbindung relativ flüchtig ist und für die beabsichtigte Anwendung möglichst feste Stoffe vorliegen sollen, die aber einen möglichst definierten Zersetzungspunkt zwischen 60°C und 80°C aufweisen sollen, wurden das zweikernige bzw. vierkernige Cobaltcarbonyl bevorzugt. Die Darstellung wird nachstehend angedeutet:

2 Co(CO)₄ → Co₂(CO)₈

Die Umsetzung erfolgt unter Energiezufuhr mit oder ohne Lösungsmittel und definierten Druckverhältnissen. Die Energiezufuhr kann durch Wärme oder UV-Einwirkung erfolgen (Thermolyse oder Fotolyse). Je nach verwendetem Metall ist die fotolytische Stabilität unterschiedlich. So sind Carbonyle des Ru und Os besonders instabil.

Das aus dem Cobalttetracarbonyl hergestellte Dimer hat einen Schmelzpunkt von etwa 100°C bei dem auch die Zersetzung erfolgt, was für höherschmelzende Legierungen Anwendung finden kann.

Vorteilhafter für typische Lotlegierungen ist die tetramere Verbindung, deren Herstellung nachstehend beschrieben ist:

2 Co₂ (CO)₈ → Co₄ (CO)₁₂ + 4 CO

Die Umsetzung kann unter Energiezufuhr in inertem Lösungsmittel erfolgen.

Für den Schmelzpunkt und die Stabilität dieser Verbindungen spielt die Auswahl des Metalls eine wichtige Rolle. Für die beabsichtigte Anwendung sind folgende Metallcarbonylverbindungen besonders geeignet: Vanadiumhexacarbonyl, Molybdänhexacarbonyl, Eisenpentacarbonyl, Manganpentacarbonyl, Nickeltetracarbonyl, Cobalttetracarbonyl und deren Oligomere. Von Bedeutung ist weiterhin, dass die physiologische Wirkung der Metallcarbonyle mit steigender Molmasse also zu Oligomeren hin günstiger wird.

Bei den Untersuchungen wurde eine messtechnische Einrichtungen verwendet, bei der die Parameter Ausgangstemperatur, Temperaturverlauf über der Zeit im abgewogenen und fertig gemischten Lotmaterial, Heizzeit und Aufheizgeschwindigkeit variabel waren:
Die Basismenge der Lotpaste für die Untersuchung wurde mit 1,1 g festgelegt. Die zugesetzten Stoffe beziehen sich auf diese Menge. Das Abwiegen und Einmischung wurde per Hand mittels Edelstahlspatel in einem Porzellantiegel vorgenommen. Nach dem Eintrag der Mischung in ein dafür vorgesehenes Pfännchen wurde die Masse genau bestimmt, das Pfännchen in die Apparatur eingesetzt und der Versuch durchgeführt und ausgewertet.

Aus der messtechnischen Erfassung der ablaufenden Reaktionen während des Lötprozesses geht eindeutig hervor, dass das Wirkprinzip zu einer Freisetzung von Energie führt. Das gilt sowohl für die Initiatorverbindung als auch für das Opfermetall. Bei der Reaktion der Opfermetalle spielte sich hauptsächlich eine Oxidation wie nachfolgend am Beispiel des Mg dargestellt ab.

2 Mg + O₂ →2 MgO

Komplizierter sind die Verhältnisse bei dem Initiator und werden mit den nachfolgenden Praktionsgleichungen nur modellhaft wiedergegeben. Wichtig ist die Zerfallreaktion der Tetracobaltverbindung in ihre Ursprungsbausteine. Die Oxidation des Kohlenmonoxid zum Kohlendioxid wird sicherlich nicht quantitativ erfolgen, dürfte aber bei der kalorischen Betrachtung eine nicht unwesentliche Rolle spielen. Die Umsetzung des Cobalts zum Cobaltoxid erfolgt normalerweise erst bei wesentlich höherer Temperatur. Es ist aber unter den gewählten Versuchsbedingungen nicht auszuschließen, dass eine teilweise Oxidation möglicherweise über das Cobalthydroxid zum Cobaltoxid erfolgt.

Sollte die gewählte Carbonylverbindung für den geplanten Anwendungsfall zu reaktiv sein oder der Schmelzpunkt zu niedrig erscheinen, ist es möglich, an derartige Verbindungen vorhandene CO-Liganden gegen andere Strukturen, z.B. Cyclopentadien auszutauschen, wodurch eine gewisse Stabilisierung des Systems erfolgt. Die sich ergebenden neuen Verbindungen zeigen in der bezeichneten Art ein abweichendes Verhalten. In den Figuren 5 und 6 sind zwei Beispiele dafür dargestellt, wobei es sich lediglich um modellhafte Darstellungen handelt, deren exakter molekularer Aufbau noch nicht abschließend geklärt ist.

Weitere Details dazu müssten im Bedarfsfall experimentell in Abhängigkeit der Aufgabenstellung ermittelt werden. Bei den bisherigen Untersuchungen wurde auch darauf verzichtet, einen geeigneten Sauerstoffträger wie z. B. ein Peroxid zu verwenden, der die Umsetzung des Kohlenmonoxid zum Kohlendioxid unterstützt. Die Gefahr der unbeabsichtigten spontanen Reaktion solcher organischer Peroxide durch metallhaltige Verbindungen, zu denen auch die behandelten Carbonyle gehören, ist bekannt. Das gilt auch für die cycloaliphatischen Peroxyketale, obwohl diese auf Grund ihrer stabileren Bindung noch am ehesten für diese Anwendung in Frage kommen. Diese Gefahr ist abhängig vom Anwendungsfall gegen den erzielten Nutzen abzuwägen.

Es hat sich auch bei den Versuchen herausgestellt, dass die Energieabgabe nicht plötzlich in einem sehr kurzen Zeitraum erfolgt, sondern über die chemische Struktur des verwendeten Initiators gesteuert werden kann. Die erzielten Ergebnisse setzen voraus, dass der Lötprozess in normaler sauerstoffhaltiger Atmosphäre erfolgt. Wenn der Wunsch besteht in einer Inertgasatmosphäre zu arbeiten, ist für die Anwesenheit eines geeigneten Sauerstoffträgers wie z.B. der vorstehend genannten Peroxide zu sorgen.

Grundsätzlich ist zur Qualität der untersuchten Stoffe zu bemerken, dass die verwendeten Hilfsstoffe ohne halogenhaltige Substanzen, ohne Säuren oder Alkalien und ohne zusätzliche Lösungsmittel bereitgestellt werden konnten, wenn man von den Substanzen absieht, die in der genannten Lotpaste vorhanden waren. Die eingesetzten Stoffe sind brennbar und neigen wie z.B. fast alle Metalle unterhalb einer bestimmten Korngröße zur Selbstentzündung. Die gesundheitsschädigende Wirkung feiner Stäube ist in vielen Fällen bekannt. Auf geeignete Schutzmaßnahmen ist daher zu achten.

Die Verfügbarkeit der Metallpulver als Handelsprodukt ist gegeben. Oligomere Carbonyle sind uns zwar als Handelsprodukte nicht bekannt, könnten aber durch den Fachmann mit Hilfe von Literaturangaben selbst angefertigt werden. Das gilt auch für die Herstellung einer benötigten Paste.

## Patentansprüche

1. Lotmaterial, enthaltend Partikel aus einer Weichlotlegierung mit einem Schmelzpunkt T_{S} oder einer unteren Grenze des Schmelzbereiches T_{S} und einen Zusatzwerkstoff, wobei die Partikel von dem Zusatzwerkstoff umgeben sind, wobei der Zusatzwerkstoff eine reaktive Komponente enthält, die bei einer Temperatur T_{R} exotherm reagiert, wobei T_{R} < T_{S} ist **dadurch gekennzeichnet, dass** die reaktive Komponente eine Metall-Carbonyl-Verbindung enthält, die mit Sauerstoff exotherm reagieren kann.

2. Lotmaterial in Form eines Lothalbzeugs aus einer Weichlotlegierung mit einem Schmelzpunkt T_{S} oder einer unteren Grenze des Schmelzbereichs T_{S}, wobei das Lothalbzeug von einem Zusatzwerkstoff umgeben oder dieser in dem Lothalbzeug enthalten ist, wobei der Zusatzwerkstoff eine reaktive Komponente enthält, die bei einer Temperatur T_{R} exotherm reagiert, wobei T_{R} < T_{S} ist,
**dadurch gekennzeichnet, dass** die reaktive Komponente eine Metall-Carbonyl-Verbindung enthält, die mit Sauerstoff exotherm reagieren kann.

3. Lotmaterial nach Anspruch 2,
**dadurch gekennzeichnet, dass** das Lothalbzeug ein Lötdraht ist.

4. Lotmaterial nach Anspruch 2,
**dadurch gekennzeichnet, dass** das Lothalbzeug ein Lotformteil ist.

5. Lotmaterial nach einem der voranstehenden Ansprüche, **dadurch gekennzeichnet, dass** die reaktive Komponente aus einem einen ersten Stoff und einen zweiten Stoff enthaltenden Gemisch besteht, wobei beide Stoffe unabhängig voneinander mit Sauerstoff exotherm reagieren können, wobei der erste Stoff eine Initiatorverbindung aus einer Metall-Carbonyl-Verbindung ist, die eine geringere Temperatur T_{R1} zur Zersetzung der Initiatorverbindung als der zweite Stoff mit einer diesbezüglichen Temperatur T_{R2} benötigt, wobei nach der Zersetzung diese Temperatur T_{R1} ausreicht, um eine exotherme Reaktion der Zersetzungsprodukte mit Sauerstoff einzuleiten.

6. Lotmaterial nach Anspruch 5,
**dadurch gekennzeichnet, dass** der zweite Stoff ein Metall oder eine Metalllegierung ist, die leichter als der Lotwerkstoff mit Sauerstoff exotherm reagiert.

7. Lotmaterial nach einem der voranstehenden Ansprüche, **dadurch gekennzeichnet, dass** in dem Zusatzstoff ein Sauerstoffträger, insbesondere ein Peroxid enthalten ist, der/das bei besagter Temperatur T_{R} Sauerstoff abgibt.

8. Trägerbauteil mit Kontaktflächen für elektrische Bauelemente oder elektrisches Bauelement mit Kontaktflächen, auf denen Lotdepots mit einem Schmelzpunkt T_{S} oder einer unteren Grenze des Schmelzbereiches T_{S} vorgesehen sind,
**dadurch gekennzeichnet, dass** die Lotdepots aus einem Lotmaterial gemäß einem der Ansprüche 1, 2 oder 4 bis 7 ausgebildet sind.

9. Verwendung eines Flussmittels mit einer reaktiven Komponente, die bei einer Temperatur T_{R} exotherm reagiert, für ein Lotmaterial aus einer Weichlotlegierung mit einem Schmelzpunkt T_{S} oder einer unteren Grenze des Schmelbereiches T_{S}, wobei T_{R} < T_{S} ist, wobei die reaktive Komponente eine Metall-Carbonyl-Verbindung ist, die mit Sauerstoff exotherm reagieren kann.

10. Verwendung nach Anspruch 9,
**dadurch gekennzeichnet, dass** die reaktive Komponente aus einem einen ersten Stoff und einen zweiten Stoff enthaltenden Gemisch besteht, wobei beide Stoffe unabhängig voneinander mit Sauerstoff exotherm reagieren können, wobei der erste Stoff eine Initiatorverbindung aus einer Metall-Carbonyl-Verbindung ist, die eine geringere Temperatur T_{R1} zur Zersetzung der Initiatorverbindung als der zweite Stoff mit einer diesbezüglichen Temperatur T_{R2} benötigt, wobei nach der Zersetzung diese Temperatur T_{R1} ausreicht, um eine exotherme Reaktion der Zersetzungsprodukte mit Sauerstoff einzuleiten.

11. Verwendung nach Anspruch 10,
**dadurch gekennzeichnet, dass** der zweite Stoff ein Metall oder eine Metalllegierung ist, die leichter als der Lotwerkstoff mit Sauerstoff exotherm reagiert.

12. Verwendung nach einem der Ansprüche 9 bis 11,
**dadurch gekennzeichnet, dass** in dem Zusatzstoff ein Sauerstoffträger, insbesondere ein Peroxid enthalten ist, der/das bei besagter Temperatur T_{R} Sauerstoff abgibt.

## Claims

1. Solder material containing particles composed of a soft solder alloy having a melting point T_{S} or a lower limit of the melting range T_{S} and an additive material, where the particles are surrounded by the additive material, the additive material contains a reactive component which reacts exothermically at a temperature T_{F} and T_{F} < T_{S}, **characterized in that** the reactive component contains a metal carbonyl compound which can react exothermically with oxygen.

2. Solder material in the form of a semifinished solder part composed of a soft solder alloy having a melting point T_{S} or a lower limit of the melting range T_{S}, where the semifinished solder part is surrounded by an additive material or the latter is present in the semifinished solder part, the additive material contains a reactive component which reacts exothermically at a temperature T_{F} and T_{R} < T_{S}, **characterized in that** the reactive component contains a metal carbonyl compound which can react exothermically with oxygen.

3. Solder material according to Claim 2, **characterized in that** the semifinished solder part is a soldering wire.

4. Solder material according to Claim 2, **characterized in that** the semifinished solder part is a shaped solder part.

5. Solder material according to any of the preceding claims, **characterized in that** the reactive component consists of a mixture containing a first material and a second material, where the two materials can react exothermically with oxygen independently of one another, the first material is an initiator compound composed of a metal carbonyl compound which requires a lower temperature T_{R1} for decomposition of the initiator compound than the second material having a temperature T_{R2} in this respect and, after decomposition, this temperature T_{R1} is sufficient to induce an exothermic reaction of the decomposition products with oxygen.

6. Solder material according to Claim 5, **characterized in that** the second material is a metal or a metal alloy which reacts exothermically with oxygen more readily than does the solder material.

7. Solder material according to any of the preceding claims, **characterized in that** an oxygen carrier, in particular a peroxide, which releases oxygen at said temperature T_{R} is present in the additive material.

8. Support component having contact areas for electric components or electric component having contact areas on which solder depots having a melting point T_{S} or a lower limit of the melting range T_{S} are provided, **characterized in that** the solder depots are composed of a solder material according to any of Claims 1, 2 or 4 to 7.

9. Use of a flux having a reactive component which reacts exothermically at a temperature T_{R} for a solder material composed of a soft solder alloy having a melting point T_{S} or a lower limit of the melting range T_{S}, where T_{R} < T_{S} and the reactive component is a metal carbonyl compound which can react exothermically with oxygen.

10. Use according to Claim 9, **characterized in that** the reactive component consists of a mixture containing a first material and a second material, where the two materials can react exothermically with oxygen independently of one another, the first material is an initiator compound composed of a metal carbonyl compound which requires a lower temperature T_{R1} for decomposition of the initiator compound than the second material having a temperature T_{R2} in this respect and, after decomposition, this temperature T_{R1} is sufficient to induce an exothermic reaction of the decomposition products with oxygen.

11. Use according to Claim 10, **characterized in that** the second material is a metal or a metal alloy which reacts exothermically with oxygen more readily than does the solder material.

12. Use according to any of Claims 9 to 11, **characterized in that** an oxygen carrier, in particular a peroxide, which releases oxygen at said temperature T_{R} is present in the additive material.

## Revendications

1. Matière à braser contenant des particules en un alliage de brasage tendre ayant un point T_{S} de fusion ou une limite inférieure du domaine T_{S} de fusion et un matériau d'additif, les particules étant entourées du matériau d'additif, le matériau d'additif contenant un constituant réactif qui réagit exothermiquement à une température T_{R}, T_{R} < T_{S},
**caractérisée en ce que**
le constituant réactif contient un composé métal-carbonyle qui peut réagir exothermiquement sur l'oxygène.

2. Matière à braser sous la forme d'un demi produit abrasif en un alliage de brasage tendre ayant un point de fusion ou une limite inférieure du domaine T_{S} de fusion, le demi produit à braser étant entouré d'un matériau d'additif ou celui-ci étant contenu dans le demi produit à braser, le matériau d'additif contenant un constituant réactif qui réagit exothermiquement à une température T_{R}, T_{R} < T_{S},
**caractérisée en ce que**
le constituant réactif contient un composé métal-carbonyle qui peut réagir exothermiquement sur l'oxygène.

3. Matière à braser suivant la revendication 2,
**caractérisée en ce que**
le demi produit à braser est un fil à braser.

4. Matière à braser suivant la revendication 2,
**caractérisée en ce que**
le demi produit à braser est une pièce conformée à braser.

5. Matière à braser suivant l'une des revendications précédentes,
**caractérisée en ce que**
le constituant réactif est constitué d'un mélange contenant une première substance et une deuxième substance, les deux substances pouvant réagir exothermiquement sur l'oxygène indépendamment l'une de l'autre, la première substance étant un composé amorceur en un composé métal-carbonyle, qui nécessite une température T_{RI} plus basse pour la décomposition du composé amorceur que la deuxième substance ayant une température T_{R2} à ce sujet, dans laquelle, après la décomposition, cette température T_{R1} suffit pour déclencher une réaction exothermique sur l'oxygène des produits de décomposition.

6. Matière à braser suivant la revendication 5,
**caractérisée en ce que**
la deuxième substance est un métal ou un alliage métallique qui réagit exothermiquement sur l'oxygène plus facilement que le matériau à braser.

7. Matière à braser suivant l'une des revendications précédentes,
**caractérisée en ce qu'**
il est contenu dans l'additif une source d'oxygène, notamment un peroxyde qui cède de l'oxygène à ladite température T_{R}.

8. Composant formant support, ayant des surfaces de contact pour des composants électriques ou composant électrique ayant des surfaces de contact, sur lesquelles sont prévus des dépôts à braser ayant un point T_{S} de fusion ou une limite inférieure du domaine T_{S} de fusion,
**caractérisé en ce que**
les dépôts à braser sont en une matière à braser suivant l'une des revendications 1, 2 ou 4 à 7.

9. Utilisation d'un flux ayant un constituant réactif, qui réagit exothermiquement à une température T_{R}, pour une matière à braser en un alliage de brasage tendre ayant un point T_{S} de fusion ou une limite inférieure du domaine T_{S} de fusion, T_{R} < T_{S}, le constituant réactif étant un composé métal-carbonyle qui peut réagir exothermiquement sur l'oxygène.

10. Utilisation suivant la revendication 9,
**caractérisée en ce que**
le constituant réactif est constitué d'un mélange contenant une première substance et une deuxième substance, les deux substances pouvant réagir exothermiquement sur l'oxygène indépendamment l'une de l'autre, la première substance étant un composé amorceur en un composé métal-carbonyle, qui nécessite une température T_{RI} plus basse pour la décomposition du composé amorceur que la deuxième substance ayant une température T_{R2} à ce sujet, dans laquelle, après la décomposition, cette température T_{R1} suffit pour déclencher une réaction exothermique sur l'oxygène des produits de décomposition.

11. Utilisation suivant la revendication 10,
**caractérisée en ce que**
la deuxième substance est un métal ou un alliage métallique qui réagit exothermiquement sur l'oxygène plus facilement que le matériau à braser.

12. Utilisation suivant l'une des revendications 9 à 11, **caractérisée en ce qu'**
il est contenu dans l'additif une source d'oxygène, notamment un peroxyde, qui cède de l'oxygène à ladite température T_{R}.
